Europäisches Patentamt

European Patent Office

Office européen des brevets

(11) Publication number: **0 404 549 A2**

# EUROPEAN PATENT APPLICATION

(21) Application number: **90306755.1**

(22) Date of filing: **20.06.90**

(51) Int. Cl.5: **G01V 3/14**

(30) Priority: **21.06.89 GB 8914229**

(43) Date of publication of application:
**27.12.90 Bulletin 90/52**

(84) Designated Contracting States:
**BE CH DE FR IT LI NL**

(71) Applicant: **THE GENERAL ELECTRIC COMPANY, p.l.c.**
**1 Stanhope Gate**
**London W1A 1EH(GB)**

(72) Inventor: **Hilsum, Cyril**
**12 Eastglade, Moss Lane**
**Pinner, Middlesex HA9 7PP(GB)**

(74) Representative: **George, Sidney Arthur**
**The General Electric Company P.l.c. Central**
**Patent Department The Hirst Research**
**Centre East Lane**
**Wembley Middlesex, HA9 7PP(GB)**

(54) **Material detection.**

(57) In a method of increasing the likelihood of detection of the presence of a material by nuclear magnetic resonance apparatus, an additive which is chosen to be readily detectable by the apparatus is incorporated in the material. The additive may, for example, comprise fluorine nuclei and/or phosphorus nuclei. The additive may be selected such that its presence characterises the particular type of material in which it is incorporated.

EP 0 404 549 A2

## Material Detection

This invention relates to material detection, and particularly to the detection of certain explosives, narcotics, drugs or other dangerous substances hidden in, for example, baggage, parcels, packages or letters. A particularly important application of the invention lies in the checking of baggage for the presence of explosives prior to its being loaded on to an aircraft.

The checking of baggage at airports conventionally involves the use of an x-ray scanner through which each item of baggage, such as a suitcase, is carried by a conveyor belt. Such a scanner will produce an image of the item on a display unit, which is watched by security personnel. The system will, however, detect only those items within the suitcase which are at least partially opaque to X-rays. Currently-used explosives such as semtex, PE4, gelignite, TNT and Cordtex (Trade Mark), are not opaque to X-rays, and would not be detected by such a system.

More recently, checking of baggage by use of nuclear magnetic resonance (NMR) has been proposed. In these NMR checking systems, a static magnetic field is applied to the item of baggage under investigation to define an equilibrium axis of magnetic alignment in the baggage. An r.f. field is then applied to the baggage in a direction orthogonal to the static magnetic field direction to excite magnetic resonance in the materials in the baggage, and resulting r.f. signals are detected and processed. The detected r.f. signals indicate the presence of compounds which contain nuclei which exhibit particular nuclear magnetic resonance characteristics. Since the above-mentioned materials contain such nuclei, the system gives a warning that such materials may be present in the baggage item. It is then necessary for the security personnel to open the item to determine whether it does, in fact, contain dangerous material or whether the material responsible for the NMR signal is harmless. Examples of such known systems are disclosed in, for example, GB-2,200,462 and W084/04173.

Our copending application (Case HRF/3598) discloses an improved NMR inspection apparatus in which an image of the material is provided.

It is an object of the present invention to increase the likelihood of detecting dangerous material using an NMR apparatus.

According to the invention there is provided a method of increasing the likelihood of detection of the presence of a material by nuclear magnetic resonance apparatus, comprising incorporating in the material an additive which is chosen to be detectable by such apparatus.

The nuclei of some elements (most notably $^1$H, $^{19}$F, $^{31}$P) have a magnetic moment. In quantum mechanical terms, this is described by a nuclear spin angular momentum quantum number, I, the value of which is an odd multiple of $\frac{1}{2}$ for nuclei with odd mass number and is integral or zero for nuclei with even mass number. Nuclei with zero spin have no nuclear magnetic moment and therefore give no NMR dipole signal. All the nuclei of interest to the present application have spin $\frac{1}{2}$ .

In a static magnetic field, quantum mechanical considerations dictate that the nuclear magnetic moments of a spin $\frac{1}{2}$ nucleus may orient either 'parallel' and 'antiparallel' to the field. It is more favourable from an energy viewpoint for the nuclei to align parallel to the field so that, in equilibrium, a small difference in the population densities of the two states (only one part in 2 million at 0.15 Tesla) occurs and a net magnetisation is produced in a macroscopic volume. The value of the net magnetisation is proportional to the nuclear magnetic moment and to the abundance of that particular nucleus in the material to be studied. If, for any reason, a non-equilibrium population distribution is produced (e.g. by the application of an RF field) then the subsequent return of the magnetisation to its equilibrium value is described by an exponential rise with a characteristic long time constant $T_1$, the so-called "spin-lattice" relaxation time.

The nuclear magnetisation is extremely small (very much smaller than the total magnetic susceptibility of water) so that its presence is detected by its interaction with AC magnetic fields usually at RF frequencies. In NMR imaging, it is usual to consider only the net magnetic moment of an assembly of nuclei and to treat this as a classical variable. The quantum mechanical properties of individual nuclei may be overlooked. In equilibrium, the net magnetic moment vector is aligned with the applied field. If, however, this moment is made to rotate to an angle, $\theta$, to the applied field, it will precess around the direction of the applied field at the Larmor precession frequency, which is proportional to the field and to a constant ($\gamma$) which is characteristic of that nucleus ($\gamma/2\pi$ = 42.6 MHz/Tesla for hydrogen). In NMR imaging, this rotation is produced by the application of a small RF magnetic field perpendicular to the main field, the angle $\theta$ being determined by the amplitude and duration of the RF pulse. Normally, rotations of 90° ($\pi/2$ pulse) and 180° ($\pi$ pulse) are used. Following one or more RF pulses to rotate the net magnetisation vector, it is the precession of the magnetisation around the static field which is detected by inductive coupling to a tuned pick-up coil.

2

Immediately following the RF pulse, the nuclear moments from all contributing nuclei are perpendicular to the applied field and start to precess in perfect synchronisation. However, two effects contributed to 'dephase' the rotation of the nuclear moments, so that an exponential decay in the effective amplitude of the signal occur with a time constant much shorter than the $T_1$ relaxation time to equilibrium. The first of these is described by a relaxation time $T_2$ (the so-called "spin-spin" relaxation time) and is a characteristic of the material. This relaxation time describes the way in which neighbouring nuclei interact due to their relative motion at the molecular level and is therefore well correlated to the viscosity of the material. In biological material, $T_2$ is generally in the range 100 to 500 milliseconds, but for explosives is typically less than 20 milliseconds.

Examples of $T_2$ values for various explosives are given in Table 1 below.

Table 1

| Material | $T_2$ (milliseconds) |
|---|---|
| PE4 | 15 |
| Gelignite | 10 |
| Cordtex | 2 |
| TNT | < 0.1 |

The second process, described by a relaxation time $T_2{}^*$, is due to the variation in the magnetic field, and hence precession frequency, across the macroscopic volume of the object, or part of an object, from which the NMR signal is derived. $T_2{}^*$ is approximately given by $1/\gamma\Delta B_o$ where $\gamma$ is the gyromagnetic ratio for the nuclei of interest and $\Delta B_o$ is the variation of field across the volume. It is therefore a reflection of the homogeneity of the magnetic field and the size of the object, and is in no way characteristic of the material. In general, the effective relaxation time, $T_2$ eff, is given by

$$\frac{1}{T_{2eff}} = \frac{1}{T_2} + \frac{1}{T_2{}^*}$$

The nucleus which is normally contained in the materials of interest and which is caused to resonate in such NMR detection is a hydrogen nucleus, but resonance of a nitrogen nucleus has also been effected. In each case the detection is difficult.

In accordance with the present invention it is proposed that the manufactures of explosive and/or other dangerous materials should incorporate in their materials an additive which includes one or more nuclei which can be more readily detected by NMR techniques. Suitable nuclei include fluorine and phosphorus.

In the case of certain explosive materials, the additive may, for example, be incorporated in a binder which is normally present in the explosive. The additive may be selected such that the added nucleus thereafter characterises the particular type of explosive, so that the NMR signal indicates not only the presence of an explosive, but also which type of explosive it is.

In checking baggage or other containers for the presence of such materials using NMR techniques, it might be advantageous to search for hydrogen nuclei first, and then, if suspicion is aroused, to check for fluorine or phosphorus or other such added nuclei.

## Claims

1. A method of increasing the likelihood of detection of the presence of a material by nuclear magnetic resonance apparatus, characterised by incorporating in the material an additive which is chosen to be readily detectable by such apparatus.

2. A method as claimed in Claim 1, characterised in that the additive includes fluorine nuclei.

3. A method as Claimed in Claim 1 or Claim 2, characterised in that the additive includes phosphorus nuclei.

4. A method as claimed in any preceding claim, characterised in that the material is an explosive and

3

the additive is incorporated in a binding material of the explosive.

5. A method as claimed in any preceding claim, characterised in that the additive is selected such that its presence characterises the particular type of material in which it is incorporated.

6. An explosive material characterised by the incorporation therein of an additive which is chosen to be readily detectable by nuclear magnetic resonance apparatus.

7. A material as claimed in Claim 6, characterised in that the additive includes fluorine nuclei.

8. A method as claimed in Claim 6, characterised in that the additive includes phosphorus nuclei.

9. A material as claimed in any one of Claims 6-8, characterised in that the additive is incorporated in a binding material of the explosive.

10. A material as claimed in any one of Claims 6-9, characterised in that the additive is selected such that its presence characterises the particular type of material in which it is incorporated.